# EUROPÄISCHE PATENTSCHRIFT

(11) **EP 1 197 578 B1**
(45) Veröffentlichungstag und Bekanntmachung des Hinweises auf die Patenterteilung: **03.08.2005**
(21) Anmeldenummer: 01121454.1
(22) Anmeldetag: 07.09.2001
(51) Int. Cl.: C23C 14/34, G05D 7/00, C23C 14/00

(54) **Sputterbeschichtigungsanlage zur Beschichtung von zumindest einem Substrat und Verfahren zur Regelung dieser Anlage**
Sputtering apparatus for coating at least one substrate and process for controlling the apparatus
Dispositif de pulvérisation pour le revêtement d'au moins un substrat et procédé de contrôle du dispositif

(30) Priorität: 11.10.2000 DE 10050354; 23.07.2001 DE 10135802
(43) Veröffentlichungstag der Anmeldung: 17.04.2002
(73) Patentinhaber: INTERPANE Entwicklungs- und Beratungsgesellschaft mbH & Co. KG, D-37697 Lauenförde (DE)
(72) Erfinder: Bechtloff, Jürgen, Prof. Dr.-Ing., 59872 Meschede (DE); Hennes, Peter, 53757 St. Augustin-Angela (DE); Czybik, Manfred, 37697 Lauenförde (DE); Böwer, Reimund, 37688 Beverungen (DE)
(74) Vertreter: Körfer, Thomas, Dipl.-Phys.

(56) Entgegenhaltungen:
- EP-A- 0 957 184
- RUSKE M ET AL: "Properties of SnO2 films prepared by DC and MF reactive sputtering" THIN SOLID FILMS, ELSEVIER-SEQUOIA S.A. LAUSANNE, CH, Bd. 351, Nr. 1-2, 30. August 1999 (1999-08-30), Seiten 146-150, XP004183083 ISSN: 0040-6090

## Beschreibung

Die Erfindung betrifft eine Sputterbeschichtungsanlage zur Beschichtung von zumindest einem Substrat, insbesondere einer Glasscheibe, und ein Verfahren zur Regelung dieser Sputterbeschichtungsanlage. Insbesondere dient die Regelung zur Regelung des Gasflusses eines Reaktivgases, das beim Sputtern zur Anwendung kommt, auf einen vorbestimmten Sollwert, d.h. zur Arbeitspunktregelung.

Eine Sputterbeschichtungsanlage gemäß dem Oberbegriff des Anspruches 1 und ein Verfahren zur Steuerung einer Sputterbeschichtungsanlage gemäß dem Oberbegriff des Anspruches 13 sind aus der DE 43 03 462 C2 bekannt. Bei der bekannten Sputterbeschichtungsanlage wird die Kathodenspannung von einer Gleichstrom- oder einer Hochfrequenz-Spannungsversorgung bereitgestellt. Die Stabilisierung einer solchen Hochfrequenz-Spannungsversorgung ist aus der EP 0 902 457 A1 bekannt. Dabei wird mittels einer Fuzzy-Regelung eine Impedanz- und Amplitudenanpassung der Spannungsversorgung an das erzeugte Plasma erreicht.

Die bekannte Regelung hat jedoch mehrere Nachteile. Beim Beschichten von einer Vielzahl von Substraten, insbesondere großflächigem Float-Glas, ist die Gleichmäßigkeit der optischen Schichteigenschaften längs und quer zur Bewegungsrichtung des Substrats ein entscheidender Güteparameter. Es ist daher insbesondere erforderlich, die Gaszusammensetzung im Gasraum konstant zu halten. Dies wird dadurch erschwert, daß die Lücke zwischen zwei aufeinanderfolgenden Substraten zu einer Störung des Anteils des Reaktivgases in dem Raum zwischen der Kathode und dem Substrat bzw. dessen Transporteinrichtung führt, was zu einem veränderten Schichtaufbau führt und damit ungünstiger ist. Erschwerend kommt hinzu, daß bei einer Erhöhung der Zufuhr des Reaktivgases in den Raum zwischen der Kathode und dem Substrat sich zugleich die Kathodenspannung verringert. Die Regelung verändert den Reaktivgasfluß und damit indirekt die Kathodenspannung. Falls die Anzahl der Entladungen über das Plasma stark ansteigt, wird, um die Anzahl der Entladungen der Kathode wieder zu verringern, Sauerstoff herausgenommen, so daß die Kathodenspannung ansteigt. In der Praxis wird diese Arbeitspunktregelung von speziell geschulten Anlagenfahrern übernommen, die den Gasfluß des Reaktivgases manuell steuern, wobei sie die Anzahl der Entladungen der Kathode über das Plasma, den Gasfluß des Reaktivgases und die Kathodenspannung der Kathode durchgehend beobachten. Dies ist allerdings sehr aufwendig und personalintensiv, da während des Sputterprozesses eine durchgehende Beobachtung erforderlich ist.

Ein Verfahren und eine Vorrichtung zum Beschichten eines Substrats ist außerdem aus der EP 0 502 242 A2 bekannt.

Der Erfindung liegt die Aufgabe zugrunde, eine Sputterbeschichtungsanlage und ein Verfahren zu deren Regelung bereitzustellen, bei denen der Gasfluß des Reaktivgases so gesteuert wird, daß ein stabiler Betrieb der Sputterbeschichtungsanlage gewährleistet ist, und bei denen insbesondere eine Regelung des Gasflusses des Reaktivgases auf einen durch den Arbeitspunkt vorgegebenen Sollwert erzielt wird.

Die Aufgabe wird durch eine Sputterbeschichtungsanlage mit den Merkmalen des Anspruches 1 und durch ein Verfahren zur Regelung einer Sputterbeschichtungsanlage mit den Merkmalen des Anspruches 13 gelöst. Vorteilhafte Weiterbildungen der in Anspruch 1 angegebenen Sputterbeschichtungsanlage sind durch die in den Ansprüchen 2 bis 12 angegebenen Maßnahmen möglich. Vorteilhafte Weiterbildungen des in Anspruch 13 angegebenen Verfahrens sind durch die in den Ansprüchen 14 bis 19 angegebenen Maßnahmen möglich.

Die erfindungsgemäße Sputterbeschichtungsanlage hat den Vorteil, daß der Gasfluß des Reaktivgases basierend auf einer Fuzzy-Logik in Abhängigkeit von der Kathodenspannung und der Anzahl der Einbrüche der Kathodenspannung, die infolge Entladung der Kathode über das Plasma auftreten, mittels einer Regelschaltung geregelt ist. Die Anzahl der Einbrüche der Kathodenspannung, die infolge Entladung der Kathode über das Plasma auftreten, kann vorzugsweise auch nur dazu herangezogen werden, die Kathodenspannung als Regelgröße zu "überbrücken", damit die Regelung nicht auf die Spannungseinbrüche reagiert. Dadurch kann der Gasfluß des Reaktivgases auch bei auftretenden Störungen, die z.B. durch Lücken zwischen den nacheinanderfolgend zu beschichtenden Substraten auftreten, auf den vorgegebenen Sollwert geregelt werden, wobei die Anzahl der Einbrüche der Kathodenspannung, die infolge Entladung der Kathode über das Plasma auftreten, erfaßt und kontinuierlich überwacht wird, um unmittelbar auf einen Anstieg dieser zu reagieren. Somit wird bei der Regelung des Gasflusses des Reaktivgases auch das ausgebildete Plasma stabilisiert, da verhindert wird, daß die Anzahl der Einbrüche der Kathodenspannung einen kritischen Wert übersteigt. Da durch die Anpassung der Fuzzy-Logik eine optimierte Regelung durch die Regelschaltung eingestellt werden kann, kann selbst bei größeren Störungen unmittelbar eine ausreichende Korrektur erfolgen, so daß stets eine gleichmäßige Beschichtung des Substrats auch bei Kundenmaßen, d. h. Substraten mit unterschiedlichen Größen, und großflächigen Substraten erreicht wird.

Die wesentlichen Vorteile sind eine bessere Ausnützung des Targetmaterials, d.h. geringere Kathoden-Leerbrennzeiten, und damit verbunden auch geringere Energiekosten zum Betrieb der Sputterbeschichtungsanlage. Des weiteren kann die optische Güte des beschichteten Substrats, insbesondere bezüglich Transmission, Reflexion und Infrarot-Reflexion, verbessert werden.

Vorteilhaft ist es, daß die Regelschaltung eine Fuzzyfizierungseinheit umfaßt, die die Meßgrößen in fuzzyfizierte Signale umsetzt. Insbesondere ist es vorteilhaft, daß ein Zeitgeber vorgesehen ist, der ein Taktsignal erzeugt, daß die die Meßgröße, die die Einbrüche der Kathodenspannung angibt, mit dem Taktsignal zu einem Signal umgesetzt wird, das die Anzahl der Einbrüche der Kathodenspannung pro Zeiteinheit angibt, und daß die Fuzzyfizierungseinheit das durch die Umsetzung erhaltene Signal fuzzyfiziert. Dadurch kann die zeitliche Dichte der Einbrüche der Kathodenspannung erfaßt werden, wobei es außerdem möglich ist, eine zeitliche Mittelung über die Anzahl der Einbrüche der Kathodenspannung zu tätigen, um ein Ausbrechen der Regelung zu verhindern.

Vorteilhaft ist es ferner, daß das Prozeßleitsystem einen Kathodenspannung-Sollwertspeicher aufweist, der einen Sollwert für die Kathodenspannung bereitstellt, daß das Prozeßleitsystem den Istwert der Kathodenspannung mit dem Sollwert der Kathodenspannung zu einem Signal verrechnet, und daß die Fuzzyfizierungseinheit das durch die Verrechnung erhaltene Signal fuzzyfiziert. Dadurch kann der Sollwert der Kathodenspannung der Kathode beliebig vorgegeben werden, wobei auch eine Anpassung während des Beschichtungsprozesses, z.B. in Abhängigkeit von der Betriebszeit des Sputtertargets oder aufgrund der Vorgabe eines Anlagenfahrers, denkbar ist, wobei bezüglich der Abweichung des gemessenen Istwerts der Kathodenspannung der Kathode von dem Sollwert eine Fuzzyfizierung erfolgt. Vorteilhaft ist es ferner, daß in dem Kathodenspannung-Sollwertspeicher mehrere Sollwerte für die Kathodenspannung der Kathode hinterlegt sind, die verschiedenen Sputtertargets zugeordnet sind, da dadurch die Umrüstung der Sputterbeschichtungsanlage auf ein anderes Sputtertarget erheblich vereinfacht ist.

Vorteilhaft ist es, daß die Regelschaltung nur dann einen neuen Wert für den Gasfluß des Reaktivgases ausgibt, wenn die Kontrolleinheit ein Freigabesignal ausgibt, und daß die Kontrolleinheit das Freigabesignal ausgibt, wenn der gemessene Istwert des Gasfluß des Reaktivgases innerhalb eines vorgegebenen Bereichs um den Sollwert des Gasflusses des Reaktivgases liegt, wobei die Kontrolleinheit Teil des Prozeßleitsystems sein kann. Dadurch ist ein Toleranzbereich vorgegeben, innerhalb dem gemessene Istwerte als ausreichende Annäherung an den Sollwert betrachtet werden, so daß verhindert wird, daß die Regelung von den tatsächlichen Prozeßparametern, z.B. infolge Übersteuerung, wegläuft, da die Kontrolleinheit das Freigabesignal, aufgrund dessen ein neuer Sollwert für den Gasfluß des Reaktivgases ausgegeben wird, nur ausgibt, wenn der gemessene Istwert den Sollwert erreicht. Somit kann zur Erhöhung der Geschwindigkeit der Regelung auch der Einfluß von externen bzw. beschichtungsprozeßbedingten Schwankungen, gedämpften Anpassungsvorgängen und dergleichen eliminiert bzw. verringert werden. Dadurch ist ferner ein Spannungsaktivierung gegeben, die dazu dient, die Regler nach dem Einfahrprozess der Kathoden und mit Glasfluß zu aktivieren, d. h. die Regler werden im laufenden Betrieb zur Arbeitspunkteinstellung aufgeschaltet.

In vorteilhafter Weise umfaßt die Regelschaltung eine Inferenzeinheit, die die von der Fuzzyfizierungseinheit ausgegebenen fuzzyfizierten Signale aufgrund von Fuzzy-Regeln miteinander verknüpft, um zumindest ein fuzzyfiziertes Ergebnissignal für den Gasfluß des Reaktivgases zu erhalten. Durch die Inferenzeinheit können die fuzzyfizierten Signale, auch wenn diese von einander widersprechenden Inhaltes sind, überlagert werden, so daß auch komplexe Prozeßzustände unmittelbar aufgelöst werden können. Die Erhöhung des Gasflusses des Reaktivgases kann unter Berücksichtigung der Anzahl der Einbrüche der Kathodenspannung, die pro Zeiteinheit auftreten, auf den diesbezüglich optimalen Wert in einem Schritt erfolgen. Im Reglerbetrieb wird der Reaktivgasfluß aber nicht von der Anzahl der Einbrüche der Kathodenspannung, die pro Zeiteiheit auftreten, gesteuert, da nur die Spannungseinbrüche eleminiert werden. Die Fuzzy-Logik ist hier einem Anlagenfahrer deutlich überlegen, da sie auch größere Änderungen des Gasflusses des Reaktivgases in kritischen Prozeßzuständen zuverlässig und schnell vornehmen kann.

Vorteilhaft ist es, daß die Regelschaltung eine Defuzzyfizierungseinheit, die das fuzzyfizierte Ergebnissignal für den Gasfluß des Reaktivgases in ein diskretes Ergebnissignal für den Gasfluß des Reaktivgases defuzzyfiziert, und ein Prozeßleitsystem umfaßt, das überwacht, ob das Ergebnissignal in einem vorgegebenen Bereich liegt, und, falls das Ergebnissignal außerhalb des zugeordneten vorgegebenen Bereichs liegt, dieses auf einen vorgegebenen Maximal- bzw. Minimalwert begrenzt, wobei der Gasfluß des Reaktivgases aufgrund des Ergebnissignals neu eingestellt wird. Durch das Prozeßleitsystem wird sichergestellt, daß der in der Sputterbeschichtungsanlage laufende Prozeß nicht durch eine zu große, durch das Ergebnissignal bedingte Änderung des Gasflusses des Reaktivgases beeinträchtigt wird.

Vorteilhaft ist es ferner, daß das Prozeßleitsystem, falls das Ergebnissignal für den Gasfluß des Reaktivgases den vorgegebenen Bereich überschritten hat, ein Fehlersignal erzeugt, das eine Bereichsüberschreitung des Ergebnissignals anzeigt. Durch das Fehlersignal kann einem Operator, insbesondere einer Bedienperson, die Bereichsüberschreitung angezeigt werden, woraufhin dieser einen Eingriff in die Regelung vornehmen kann. Das erzeugte Fehlersignal kann auch zur Protokollierung des Einfahr- bzw. Beschichtungsprozesses verwendet werden, um insbesondere auf den vorgegebenen Sollwert für den Gasfluß des Reaktivgases Einfluß zu nehmen.

In vorteilhafter Weise gibt die Kontrolleinheit, falls das Prozeßleitsystem ein Fehlersignal erzeugt, solange kein Freigabesignal, das die Ausgabe eines neuen Wertes für den Gasfluß des Reaktivgases freigibt, aus, bis durch einen Operator, insbesondere eine Bedienperson, die Ausgabe wieder freigegeben ist. Dadurch kann, insbesondere bei kritischen Prozessen, eine Erneuerung des Sollwerts für den Gasfluß des Reaktivgases verhindert werden, um den Prozeß auf den ursprünglich vorgegebenen Sollwert zu stabilisieren, wobei die erneute Freigabe im Ermessen des Operators liegt. Wird die Sputterbeschichtungsanlage von einer Bedienperson überwacht, dann ergibt sich außerdem der Vorteil, daß, wenn an mehreren Sputterkammern oder Kathoden der Gesamtsputteranlage, die das gesamte Schichtsystem auf das Substrat aufbringt, und/oder an mehreren Sputterbeschichtungsanlagen zur gleichen Zeit Fehlersignale erzeugt werden, die Bedienperson die Fehler der einzelnen Sputterkammern oder Kathoden der Gesamtsputteranlage und/oder der einzelnen Sputterbeschichtungsanlagen nacheinander abarbeiten kann.

Vorteilhaft ist es ferner, daß, falls das Prozeßleitsystem ein Fehlersignal erzeugt und durch den Operator die Ausgabe des Freigabesignals der Kontrolleinheit freigegeben ist, die Kontrolleinheit das Freigabesignal sogar dann ausgibt, wenn das Ergebnissignal für den Gasfluß des Reaktivgases weiterhin außerhalb des vorgegebenen Bereichs liegt. Dadurch kann der Operator, insbesondere bei unkritischen Prozessen, erzwingen, daß der Beschichtungsprozeß unbeeinflußt fortgesetzt wird.

Das erfindungsgemäße Verfahren zur Regelung einer Sputterbeschichtungsanlage hat den Vorteil, daß eine Regelung des Gasflusses des Reaktivgases gegeben ist, die auftretende Störungen, z.B. infolge einer Lücke zwischen zwei aufeinanderfolgenden Substraten, unter Berücksichtigung der Anzahl der Einbrüche der Kathodenspannung, die pro Zeiteinheit auftreten, unmittelbar und schnell ausgleicht. Daher weisen die optischen Eigenschaften, insbesondere Transmission, Reflexion und Infrarot-Reflexion, der mit der Sputterbeschichtungsanlage beschichteten Substrate eine höhe Güte auf, selbst wenn diese großflächig sind.

Vorteilhaft ist es, daß die Anzahl der Einbrüche der Kathodenspannung unter Verwendung eines Taktsignals in ein Signal umgesetzt wird, das die Anzahl der Einbrüche der Kathodenspannung pro Zeiteinheit angibt, und daß dieses Signal bezüglich der linguistischen Variablen "wenig", "mittel" und "viel" fuzzyfiziert wird; und daß der Istwert der Kathodenspannung von einem Sollwert der Kathodenspannung abgezogen wird und das Ergebnis bezüglich der linguistischen Variablen "negativ", "Null" und "positiv" zu einem fuzzyfizierten Signal fuzzyfiziert wird; daß die fuzzyfizierten Signale gemäß vorgegebenen Fuzzy-Regeln miteinander verknüpft werden, wodurch ein bezüglich der linguistischen Variablen "wenig", "mittel" und "viel" fuzzyfiziertes Ergebnissignal für den Gasfluß erhalten wird; und daß das fuzzyfizierte Ergebnissignal auf ein diskretes Ergebnissignal defuzzyfiziert wird. Das fuzzyfizierte Signal, das sich aus der Differenz von dem Istwert der Kathodenspannung und dem Sollwert der Kathodenspannung ergibt, und das fuzzyfizierte Signal, das sich aus der Anzahl der Einbrüche der Kathodenspannung pro Zeiteinheit ergibt, werden mittels Fuzzy-Regeln zum Erhalten der fuzzyfizierten Ergebnissignale miteinander überlagert bzw. zur Inferenz gebracht, wobei vorgegebene Fuzzy-Regeln die Verknüpfung der fuzzyfizierten Signale vorgeben. In vorteilhafter Weise umfassen die Fuzzy-Regeln dabei folgende Regeln: Die Verknüpfung von "wenig" und "negativ" wird auf "viel" abgebildet, die Verknüpfung von "wenig" und "Null" wird auf "mittel" abgebildet und die Verknüpfung von "wenig" und "positiv" wird auf "viel" abgebildet. Im Rahmen der Fuzzy-Logik kann die Verknüpfung, die insbesondere als UND-Verknüpfung bezeichnet wird, je nach Prozeß definiert werden. Zum Beispiel kann durch die Wahl der Verknüpfung eine eher prozeßstabilisierende oder eine eher prozeßbeschleunigende Vorgabe für die Ergebnissignale erreicht werden. Für kritische Prozesse wird in vorteilhafter Weise die Verknüpfung der Zugehörigkeitsgrade zu den linguistischen Variablen mittels der Minimumsfunktion definiert. Die Minimumsfunktion ist so definiert, daß sie zwei reelle Zahlen, insbesondere zwei Zahlen zwischen 0 und 1, auf die kleinere der beiden Zahlen abbildet. Die UND-Verknüpfung kann auch anders definiert werden, insbesondere durch UND (a, b) = ab/(a+b-ab) oder durch UND (a, b) = (ab)^{1-λ}(1-(1-a) (1-b))^{λ}. Dabei ist die letzte Verknüpfung das kompensierende UND, das für λ = 0 bis 1 zwischen UND und ODER interpoliert. Durch das kompensierende UND kann dem Erfahrungswissen der Anlagenfahrer besser entsprochen werden, da dies der sprachlichen Ausdrucksweise näher kommt. Wenn beispielsweise der unscharfe Begriff "Gasfluß des Reaktivgases viel" definiert wird durch "Anzahl der Einbrüche pro Zeiteinheit wenig" UND "Sollwert minus Istwert der Kathodenspannung negativ", dann ist implizit gemeint, daß eine etwas geringere Anzahl der Einbrüche der Kathodenspannung pro Zeiteinheit den Effekt von einem etwas größeren Istwert der Kathodenspannung aufwiegen kann und umgekehrt. Das kompensierende UND ist ein Mittelding zwischen dem logischen UND und dem logischen ODER, das diesem sprachlichen Gebrauch Rechnung trägt. Für λ = 0 ergibt sich die Minimumsfunktion, während für λ = 1 das kompensierende UND zur Maximumsfunktion, also dem logischen ODER wird. Zwischenwerte von λ interpolieren zwischen UND und ODER, so daß eine Anpassung des kompensierenden UNDs möglich ist.

Alternativ ist es vorteilhaft, daß die fuzzyfizierten Signale gemäß vorgegebenen Fuzzy-Regeln miteinander verknüpft werden, wodurch ein bezüglich der linguistischen Variablen "wenig", "konstant" und "mehr" fuzzyfiziertes Ergebnissignal für den Gasfluß erhalten wird; und daß das fuzzyfizierte Ergebnissignal auf ein diskretes Ergebnissignal defuzzyfiziert wird. Dabei umfassen die Fuzzy-Regeln in vorteilhafter Weise die Regeln, daß "wenig" UND "negativ" gleich "mehr" ist, daß "wenig" UND "Null" gleich "konstant" ist, daß "wenig" UND "positiv" gleich "weniger" ist, daß "mittel" gleich "konstant" ist und daß "viel" gleich "konstant" ist. Dadurch ist eine relative Regelung des Gasflusses des Reaktivgases gegeben, bei der die Vorgabe eines Sollwerts für den Gasfluß des Reaktivgases nicht erforderlich ist.

In vorteilhafter Weise verknüpft die in den Fuzzy-Regeln angegebene UND-Verknüpfung die Zugehörigkeitsgrade zu den linguistischen Variablen "wenig", "negativ", "Null" und "positiv" mittels der Minimumsfunktion, um eine prozeßstabilisierende Regelung zu erzielen.

Ausführungsbeispiel der Erfindung sind anhand der nachfolgenden Beschreibung unter Bezugnahme auf die Zeichnungen näher beschrieben. Es zeigen:
- Fig. 1: ein Ausführungsbeispiel einer Sputterbeschichtungsanlage;
- Fig. 2: die in Fig. 1 dargestellte Sputterbeschichtungsanlage in einem Blockschaltbild;
- Fig. 3: die in Fig. 2 dargestellte Fuzzyfizierungseinheit im Detail;
- Fig. 4A und 4B: Teile des in Fig. 3 dargestellten Fuzzyfizierungsglieds der Fuzzyfizierungseinheit im Detail;
- Fig. 5: ein Detail der in Fig. 2 dargestellten Inferenzeinheit;
- Fig. 6A und 6B: Teile der in Fig. 2 dargestellten Defuzzyfizierungseinheit im Detail; und
- Fig. 7: einen Signalflußplan eines weiteren Ausführungsbeispiels zur Regelung einer Sputterbeschichtungsanlage.

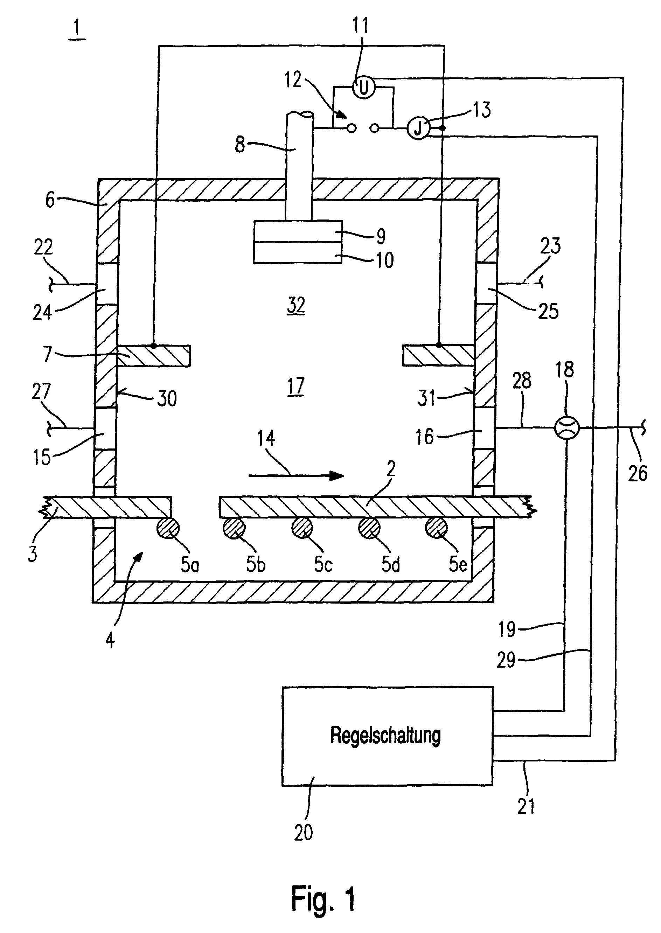

Fig. 1 zeigt ein Ausführungsbeispiel einer Sputterbeschichtungsanlage 1. Die Sputterbeschichtungsanlage 1 dient insbesondere zur Beschichtung von Substraten 2, 3, die aufeinanderfolgend durch die Sputterbeschichtungsanlage 1 in Transportrichtung 14 geschleust werden. Speziell können dadurch als großflächige Float-Glasscheiben ausgebildete Substrate 2, 3 mittels der Sputterbeschichtungsanlage 1 beschichtet werden. Zum Transport der Substrate 2, 3 weist die Sputterbeschichtungsanlage 1 eine Transporteinrichtung 4 auf, die die Transportrollen 5a bis 5e umfaßt, so daß eine Vielzahl von Substraten 2, 3 aufeinanderfolgend beschichtet werden kann. Die erfindungsgemäße Sputterbeschichtungsanlage eignet sich allerdings auch für andere Anwendungsfälle, insbesondere zum Beschichten von einzelnen Substraten.

Die Sputterbeschichtungsanlage 1 weist ein Gehäuse 6 und eine mit dem Gehäuse 6 mechanisch verbundene, als Anodenblende ausgebildete Anode 7 auf, die gegenüber dem Gehäuse 6 elektrisch isoliert ist. Außerdem ist ein Kathodenhalter 8 vorgesehen, der ebenfalls mit dem Gehäuse 6 verbunden und gegenüber diesem elektrisch isoliert ist. Der Kathodenhalter 8 hält eine Kathode 9, an die ein Sputtertarget 10 befestigt ist. Die Kathode 9 wird gegenüber der Anode 7 mit einer Spannung U beaufschlagt, die sowohl durch eine Gleich-, Mittelfrequenz-, Puls-, eine Hochfrequenzspannung oder dergleichen gegeben sein kann. Dadurch liegt an der Kathode 9 eine Kathodenspannung an, die von einem Spannungsmeßgerät 11 gemessen wird, das parallel zu der die Kathode versorgenden Spannungsquelle 12 geschaltet ist. Zwischen die Spannungsquelle 12 und die Anode 7 ist ein Strommeßgerät 13 geschaltet, das den Kathoden- bzw. Anodenstrom mißt. Das Strommeßgerät 13 kann auch zwischen die Spannungsquelle 12 und die Kathode 9 geschaltet sein.

Mittels des Spannungsmeßgeräts 11 und des Strommeßgeräts 13 werden die Kathodenspannung der Kathode und der Kathodenstrom gemessen, woraus sich die Kathodenleistung ermitteln läßt. Beispielhafte Werte sind 0 bis 60 V für die Kathodenspannung und 0 bis 70 A für den Kathodenstrom, wobei der Arbeitsbereich der Kathodenspannung in Abhängigkeit des verwendeten Targets, z.B. für Nickelchrom bei ca. 460 V liegt. Die Spannungsquelle 12 kann dabei beispielsweise für maximal 40 kW ausgelegt sein, so daß die Kathode 9 mit maximal 40 kW versorgt wird. Die Anode 7 ist nicht notwendigerweise mit Masse verbunden und kann, insbesondere in Abhängigkeit von Ablagerungen des Targetmaterials auf dieser, eine positive Anodenspannung aufweisen, die z.B. zwischen 0 und 80 V bei einem Anodenstrom von 0 bis 70 A liegt.

In den Raum 32 zwischen der Kathode 9 bzw. dem Sputtertarget 10 und der Anode 7 wird als Arbeitsgas ein Inertgas, beispielsweise Argon, geleitet. Durch Anlegen der Kathodenspannung zwischen Kathode 9 und Anode 7 zündet zum Bewirken des Sputterprozesses ein Plasma. Dieses entsteht, wenn durch Zusammenstöße mit Elektronen schwere, positiv geladene Ionen aus den Atomen des Inertgases erzeugt werden. Die hohe Spannung erzeugt ein starkes elektrisches Feld, das die schweren, positiv geladenen Ionen zur Kathode hin beschleunigt. Die entstandenen schweren, positiv geladenen Ionen werden auf die negativ geladene Kathode 9 zu beschleunigt, auf der das aus dem Beschichtungsmaterial bestehende Sputtertarget 10 befestigt ist. Die mit hoher Energie auftreffenden Ionen schlagen aus dem Sputtertarget 10 Material heraus, das sich anschließend auf den Substraten 2 bzw. 3 niederschlägt. In Abhängigkeit von der Beschichtungsrate und der Transportgeschwindigkeit der Substrate 2, 3 in der Transportrichtung 14, die durch den Transport mittels der Transportrollen 5a bis 5e der Transporteinrichtung 4 erreicht wird, scheidet sich auf den Substraten 2, 3 eine aus dem Material des Sputtertargets 10 bestehende dünne Schicht von vorgegebener Schichtdicke ab. Indem die Substrate 2, 3 mehrere der beschriebenen Sputterkammern durchlaufen, kann auf den Substraten 2, 3 ein beliebiges Schichtsystem ausgebildet werden.

Die Sputterbeschichtungsanlage 1 dient zum Sputtern von Targetmaterialien in einer Reaktivgasatmosphäre, die z.B. aus Sauerstoffgas oder Stickstoffgas besteht. Das Reaktivgas wird dabei durch einen Gaseinlaß 15, 16 in den Raum 17 zwischen der Anode 7 und den Substraten 2, 3 bzw. der die Substrate 2, 3 befördernden Transporteinrichtung 4 geleitet. Der Gasfluß des Reaktivgases wird dabei über zumindest einen Gasflußregler oder Massflowmeter 18 geregelt, wobei der Gasfluß des Reaktivgases über eine Leitung 19 an eine Regelschaltung 20 gemeldet wird. Die Regelschaltung 20 erfaßt außerdem über die Leitung 29 den Kathodenstrom der Kathode 9, der von dem Strommeßgerät 13 gemessen wird, und über die Leitung 21 die Kathodenspannung der Kathode, die von dem Spannungsmeßgerät 11 gemessen wird. Durch die zeitliche Erfassung der Kathodenspannung der Kathode 9 ermittelt die Regelschaltung 20 die Anzahl der Einbrüche der Kathodenspannung, die infolge Entladung der Kathode über das Plasma auftreten. In Abhängigkeit von der Kathodenspannung der Kathode 9 und der Anzahl der Einbrüche der Kathodenspannung, die infolge Entladung der Kathode über das Plasma auftreten, steuert die Regelschaltung 20, die auf einer Fuzzy-Logik basiert, den Gasfluß des Reaktivgases mittels einer Drossel, die in der Drosseleinheit 18 vorgesehen ist. Hierdurch wird insbesondere berücksichtigt, daß durch eine Erhöhung des Gasflusses des Reaktivgases die Kathodenspannung der Kathode 9 verringert wird und umgekehrt. Abhängig von dem Erfahrungswissen der Anlagenfahrer können mit verschiedensten Materalien Fuzzyregeln aufgestellt werden und diese können relativ einfach mit der Fuzzyeinheit in die Regeltechnik umgesetzt werden, wobei der Vorteil überproportional wächst, wenn mehr als eine Regelgröße vorliegt, was einem nicht linearen Regler entspricht.

Das Reaktivgas wird über die Gasleitung 26 zu dem Gasflußregler 18 und von dort über die Gasleitungen 27, 28 zu den Gaseinlässen 15, 16 des Gehäuses 6 der Sputterbeschichtungsanlage 1 geleitet.

Um das zum Funktionieren des Sputterprozesses insbesondere in den Räumen 17, 32 benötigte Vakuum zu schaffen, ist ein Pumpensystem vorgesehen, das den Innenraum des Gehäuses 6 über Gasleitungen 22, 23 durch in dem Gehäuse 6 vorgesehene Gasaustrittsöffnungen 24, 25 auspumpt. Beim Betrieb des Plasmas herrscht im Bereich des Plasmas beispielsweise ein Druck von 1 · 10⁻³ bis 5 · 10⁻³ mbar bei einem Druck des Restgases von 10⁻⁵ mbar, ohne Berücksichtigung eines eventuellen Reaktivgasflusses.

Das zum Auspumpen des Gehäuses 6 der Sputterbeschichtungsanlage 1 verwendete Pumpensystem kann z.B. aus einer Anordnung von mehreren Turbomolekularpumpen, die an geeignete Vorpumpen angeschlossen sind, bestehen.

In dem beschriebenen Ausführungsbeispiel ist die Anode 7 als Anodenblende ausgebildet, wobei sie zur elektrischen Stabilisierung des Plasmas dient. Dadurch kann die Eigenschaft und Güte der auf die Substrate 2, 3 aufgesputterten Schicht verbessert werden, Insbesondere wird eine gleichmäßige Schichtdicke und eine hohe Homogenität erreicht.

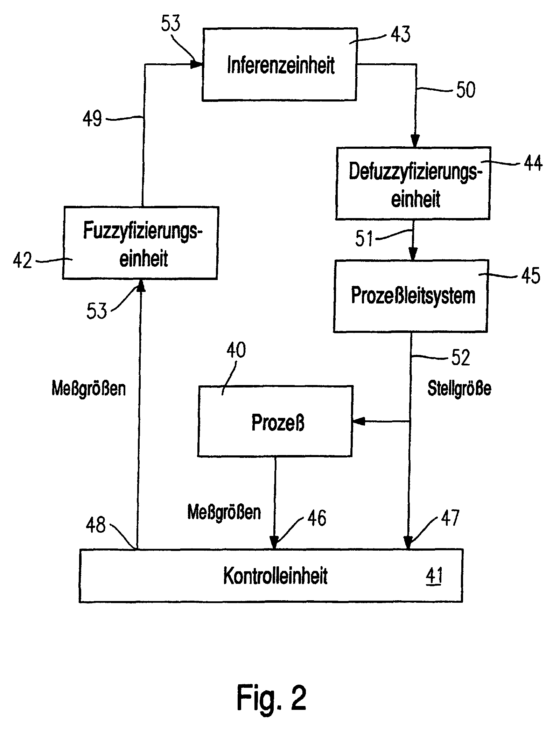

Fig. 2 zeigt die anhand der Fig. 1 beschriebene Sputterbeschichtungsanlage 1 in einer schematischen Darstellung, wobei Teile der Regelschaltung 20 aufgegliedert dargestellt sind. Bereits beschriebene Elemente sind in dieser und in allen anderen Figuren mit übereinstimmenden Bezugszeichen versehen, wodurch sich eine wiederholende Beschreibung erübrigt.

In der Sputterbeschichtungsanlage 1 ist die Kathodenspannung der Kathode 9 in Abhängigkeit von dem verwendeten Sputtertarget 10 durch einen Sollwert für die Kathodenspannung im Arbeitspunkt vorgegeben. Allerdings wird die Kathodenspannung der Kathode 9 auch durch den Gasfluß bzw. den im Raum 17 herrschenden Partialgasdruck des Reaktivgases beeinflußt. Diese und weitere Prozeßparameter definieren einen Prozeß 40, der zum Beschichten der Substrate 2, 3 durchgeführt wird. Weitere Prozeßparameter sind z.B. die Einbrüche der Kathodenspannung (ARC), die infolge Entladung der Kathode über das Plasma auftreten. Die Prozeßparameter des Prozesses 40 werden gemessen und an die Kontrolleinheit 41 der Steuerschaltung 20 übergeben. Die Meßgrößen umfassen die Meßgröße, die die Kathodenspannung angibt, und die Meßgröße, die die Einbrüche der Kathodenspannung angibt, die infolge Entladung der Kathode 9 über das Plasma auftreten. Die Meßgrößen werden mittels mehrerer Einheiten 42 bis 45 verarbeitet, wodurch zumindest eine Stellgröße erhalten wird, die den Sollwert des Gasflusses des Reaktivgases des Gasflußreglers 18, der wiederum einen eigenen Regler besitzt, einstellt. Dabei werden von der Kontrolleinheit 41 fortlaufend die Meßgrößen des Prozesses 40 aufgrund der vorliegenden Prozeßparameter erfaßt und mit der Stellgröße, die den Gasfluß des Reaktivgases angibt, verglichen, wobei die Kontrolleinheit 41 die Ermittlung neuer Stellgrößen durch die Einheiten 42 bis 45 freigibt, wenn die bestehenden Meßgrößen in geeigneter Beziehung zu der ermittelten Sollgröße stehen. Die Kontrolleinheit 41 umfaßt dazu einen Eingang 46, über den die aus den Prozeßparametern des Prozesses 40 ermittelten Meßgrößen übergeben werden, und einen Eingang 47, über den die Stellgröße von dem Prozeßleitsystem 45 übergeben wird. Außerdem umfaßt die Kontrolleinheit einen Ausgang 48 zur Übergabe der Meßgrößen an die Fuzzyfizierungseinheit 42.

Die Fuzzyfizierungseinheit 42 ist mittels der Signalleitung 49 mit der Inferenzeinheit 43 verbunden, die mittels einer weiteren Signalleitung 50 mit der Defuzzyfizierungseinheit 44 verbunden ist. Die Defuzzyfizierungseinheit 44 ist wiederum mittels einer Signalleitung 51 mit der Überwachungseinheit 45 verbunden. Das Prozeßleitsystem 45 gibt die von den Einheiten 42 bis 45 ermittelte Stellgröße für den Gasfluß des Reaktivgases mittels der Verbindung 52 zum einen an den Prozeß 40 und zum anderen an die Kontrolleinheit 41 weiter.

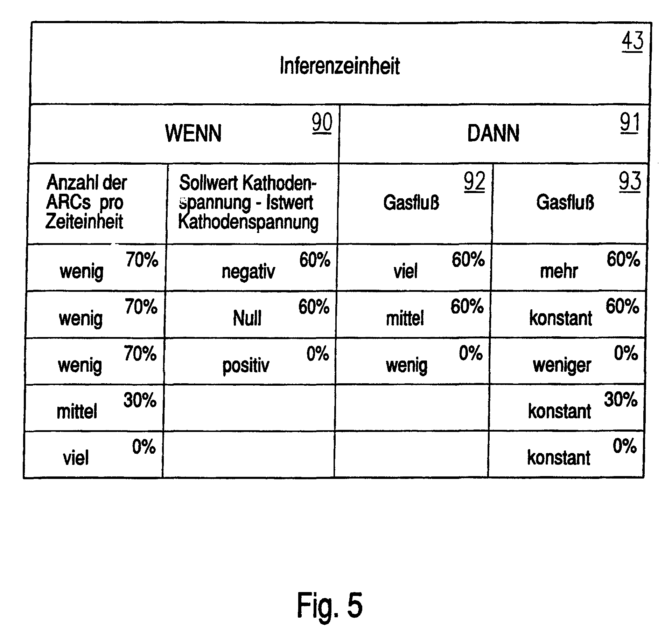

Die Regelschaltung 20 weist dabei zwei Betriebsarten auf, durch die eine unterschiedliche Einwirkung auf den Gasfluß des Reaktivgases erreicht wird. In der ersten Betriebsart sind die Einheiten 42 bis 45 so geschaltet, daß sie eine Vorgabe für die Stellgröße ausgeben, die eine absolute Vorgabe für den Gasfluß des Reaktivgases darstellt. In einer zweiten Betriebsart sind die Einheiten 42 bis 45 so geschaltet, daß sie eine relative Vorgabe, d.h. eine Änderung für den Gasfluß des Reaktivgases vorgeben. Somit kann durch die Einheiten 42 bis 45 entweder ein absoluter Vorgabewert für den Gasfluß des Reaktivgases ermittelt werden oder eine Vorgabe, die angibt, um wieviel der Gasfluß des Reaktivgases zu ändern ist, ermittelt werden, was in der nachfolgenden Beschreibung, insbesondere unter Bezugnahme auf Fig. 5, näher beschrieben ist.

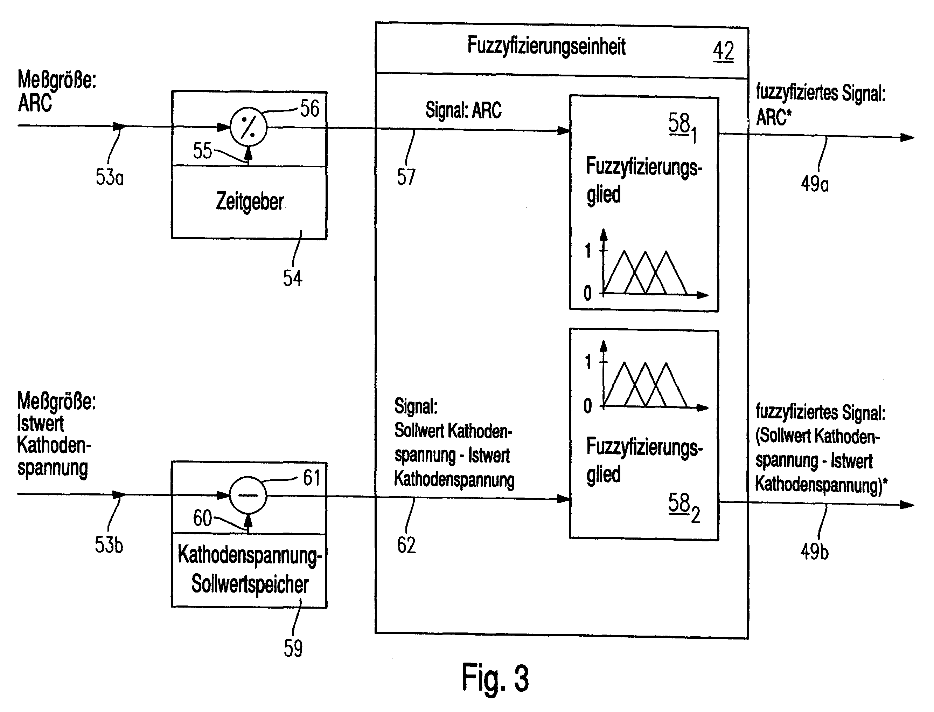

Fig. 3 zeigt die in Fig. 2 dargestellte Fuzzyfizierungseinheit 42 im Detail.

Die Fuzzyfizierungseinheit 42 weist die Eingänge 53a und 53b auf, die in Fig. 2 zu dem Eingang 53 zusammengefaßt sind. Über den Eingang 53a wird die Meßgröße ARC, d.h. die Meßgröße, die die Einbrüche der Kathodenspannung, die infolge Entladung der Kathode 9 über das Plasma auftreten, angibt, an die Fuzzyfizierungseinheit 42 übertragen. Über den Eingang 53b wird die Meßgröße, die den Istwert der Kathodenspannung der Kathode 9 angibt, an die Fuzzyfizierungseinheit 42 übergeben.

Ferner ist ein Zeitgeber 54 vorgesehen, der ein Taktsignal erzeugt und dieses über eine Signalleitung 55 an eine Verrechnungseinheit 56 abgibt. Die Verrechnungseinheit 56 verrechnet die erfaßte Meßgröße ARC durch Division mit dem Taktsignal zu einem Signal ARC, das die Anzahl der Einbrüche der Kathodenspannung pro Zeiteinheit angibt, wobei dieses Signal von der Verrechnungseinheit 56 über die Signalleitung 57 an ein Fuzzyfizierungsglied 58 geleitet wird. Das Fuzzyfizierungsglied 58₁ fuzzyfiziert das Signal ARC, das die Anzahl der Einbrüche der Kathodenspannung pro Zeiteinheit angibt, zu einem fuzzyfizierten Signal ARC* und gibt dieses über eine Signalleitung 49a aus.

Über den Eingang 53b der Fuzzyfizierungseinheit 42 wird die Meßgröße, die den Istwert der Kathodenspannung der Kathode 9 angibt, an die Fuzzyfizierungseinheit 42 übergeben. Ferner ist ein Kathodenspannung-Sollwertspeicher 59 vorgesehen, der einen Sollwert für die Kathodenspannung der Kathode 9 bereitstellt und über die Signalleitung 60 an die Verrechnungseinheit 61 übergibt. Der Sollwertspeicher kann dabei auch in Form einer Tabelle hinterlegt sein, deren Sollwerte in Abhängigkeit einer geeigneten Prozeßzeit linear interpoliert werden, so daß auch Zwischenwerte als Sollwerte für die Kathodenspannung der Kathode 9 bereitgestellt werden können. Die Verrechnungseinheit 61 bildet die Differenz zwischen dem Sollwert der Kathodenspannung der Kathode 9 und dem Istwert der Kathodenspannung der Kathode 9 und gibt das erhaltene Signal über die Signalleitung 62 an das Fuzzyfizierungsglied 58₂ aus. Dabei gibt das ausgegebene Signal die Differenz zwischen dem Sollwert und dem Istwert der Kathodenspannung der Kathode 9 an. Das Fuzzyfizierungsglied 58₂ fuzzyfiziert das erhaltene Signal, das die Differenz zwischen dem Sollwert und dem Istwert der Kathodenspannung der Kathode 9 angibt, zu einem fuzzyfizierten Signal und gibt dieses über die Signalleitung 49b an die Inferenzeinheit 43 aus.

Die Signalleitungen 49a und 49b, über die die fuzzyfizierten Signale von der Fuzzyfizierungseinheit ausgegeben werden, sind in Fig. 2 zu der Signalleitung 49, die die Signalverbindung zwischen der Fuzzyfizierungseinheit 42 und der Inferenzeinheit 43 darstellt, zusammengefaßt.

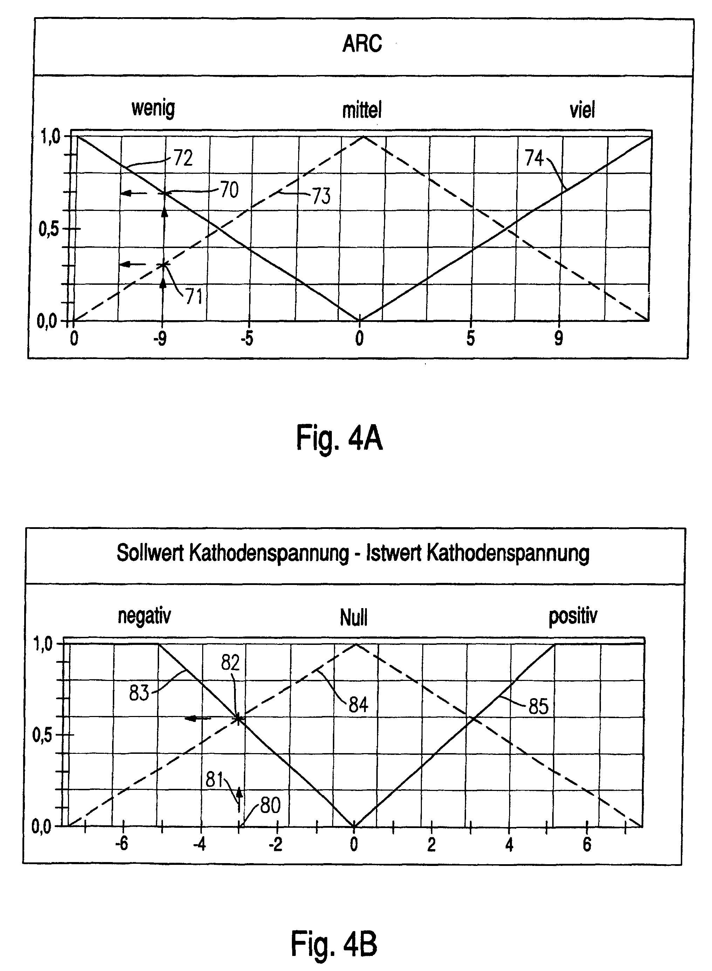

Der Sollwert für die Kathodenspannung der Kathode 9 wird von dem Kathodenspannung-Sollwertspeicher 59 in Abhängigkeit von dem Sputtertarget 10, d.h. insbesondere abhängig von dem Material des Sputtertargets 10, bereitgestellt. Dadurch wird der Wechsel des Sputtertargets 10, insbesondere hin zu einem anderen Material des Sputtertargets, erheblich vereinfacht, da die jeweils benötigten Sollwerte bereits bereitstehen. Im folgenden wird anhand der Fig. 4A und 4B die Fuzzyfizierungseinheit 42, insbesondere deren Fuzzyfizierungsglied 58, näher erläutert. Zur Veranschaulichung werden hierfür beispielhafte Signale verwendet, die in willkürlichen Einheiten angegeben sind.

Die in Fig. 2 dargestellte Kontrolleinheit 41 ermittelt aus der Kathodenspannung die Meßgröße, die die Einbrüche der Kathodenspannung der Kathode 9, die infolge der Entladung der Kathode über das Plasma auftreten, angibt und leitet diese zur Weiterverarbeitung durch die Fuzzyfizierungseinheit 42 weiter. Mittels des Zeitgebers 54 und der Verrechnungseinheit 56 wird diese Meßgröße zuvor noch zu einem Signal ARC umgesetzt, das die Anzahl der Einbrüche der Kathodenspannung pro Zeiteinheit angibt. Dieses Signal wird in dem Fuzzyfizierungsglied 58₁ zu einem fuzzyfizierten Signal ARC* fuzzyfiziert. Wie in Fig. 4A dargestellt, sind drei Fuzzy-Mengen vorgesehen, die das Signal ARC bezüglich der linguistischen Variablen "wenig", "mittel" und "viel" aufteilen. Ist beispielsweise die Größe des ARC-Signals gleich -9, dann ist der Zugehörigkeitsgrad zu "wenig" gleich 0,7 = 70 % und der Zugehörigkeitsgrad zu "mittel" gleich 0,3 = 30 %, während der Zugehörigkeitsgrad zu "viel" gleich 0 ist. Die Zugehörigkeitsgrade werden dabei ermittelt, indem die Schnittpunkte 70, 71 mit den den linguistischen Variablen "wenig", "mittel" und "viel" zugeordneten Kurven ermittelt werden. Dabei ergibt sich ein Schnittpunkt 70 mit der Kurve 72 für "wenig" auf der Höhe von 0,7 und ein Schnittpunkt mit der Kurve 73 für "mittel" auf der Höhe 0,3. Mit der Kurve 74 für "viel" ergibt sich kein Schnittpunkt, so daß der entsprechende Zugehörigkeitsgrad gleich 0 ist.

Die in Fig. 2 dargestellte Kontrolleinheit 41 leitet der Fuzzyfizierungseinheit 42 zur Weiterverarbeitung außerdem die Meßgröße zu, die den Istwert der Kathodenspannung der Kathode 9 angibt. Die Verrechnungseinheit 61 erzeugt zuvor noch das Signal, das die Differenz aus dem Sollwert der Kathodenspannung und dem Istwert der Kathodenspannung angibt, und sendet dieses an das Fuzzyfizierungsglied 58₂ zur Fuzzyfikation. Dieses Signal wird in dem Fuzzyfizierungsglied 58₂, wie in Fig. 4B dargestellt, bezüglich der linguistischen Variablen "negativ", "Null" und "positiv" zerlegt, wodurch die jeweiligen Zugehörigkeitsgrade zu den Fuzzy-Mengen ermittelt werden. Liegt beispielsweise der Istwert der Kathodenspannung um drei Einheiten oberhalb des Sollwerts, dann ergibt sich für die Differenz zwischen dem Sollwert der Kathodenspannung und dem Istwert der Kathodenspannung ein Wert von -3 Einheiten, so daß sich für den Zugehörigkeitsgrad zu "negativ" 60 %, den Zugehörigkeitsgrad zu "Null" 60 % und für den Zugehörigkeitsgrad zu "positiv" 0 % ergibt. Diese Werte werden erhalten, indem vom Abszissenwert -3 (Bezugszeichen 80) aus in der Richtung 81 der Schnittpunkt 82 mit den Kurven, die den linguistischen Variablen zugeordnet sind, ermittelt wird. Der Schnittpunkt 82 stellt sowohl den Schnittpunkt mit der "negativ"-Kurve 83 als auch mit der "Null"-Kurve 84 dar, wobei sich in beiden Fällen ein Zugehörigkeitsgrad von 60 % ergibt. Mit der "positiv"-Kurve 85 ergibt sich kein Schnittpunkt, so daß der entsprechende Zugehörigkeitsgrad 0 % ist.

Die in Fig. 4B dargestellte "negativ"-Kurve 83 berücksichtigt, daß unterhalb eines Schwellenwertes von -5 die Abweichung des Istwerts der Kathodenspannung von dem Sollwert der Kathodenspannung als zu 100 % "negativ" zu beurteilen ist, während oberhalb eines Schwellenwertes von +5 die Abweichung des Istwerts der Kathodenspannung von dem Sollwert der Kathodenspannung als zu 100 % positiv zu beurteilen ist. Allerdings ist die Zugehörigkeitsfunktion zur Fuzzy-Menge "Null" auch außerhalb des Bereichs von -5 bis 5 größer als 0 %, um einen verringerten aber doch merklichen Einfluß auch für große Abweichungen zu erhalten. Dadurch kann einer starken Abweichung des Istwerts der Kathodenspannung von dem Sollwert mit einer größeren Korrektur begegnet werden.

Die von der Fuzzyfizierungseinheit 42 aus den Meßgrößen erhaltenen fuzzyfizierten Signale werden über die Signalleitung 49 an die Inferenzeinheit 43 weitergeleitet. Die in Fig. 2 dargestellte Inferenzeinheit 43 überlagert die fuzzyfizierten Signale, d.h. sie bringt diese zur Inferenz, und ermittelt aufgrund vorgegebener Fuzzy-Regeln fuzzyfizierte Ergebnissignale für den Gasfluß des Reaktivgases.

In Fig. 5 ist eine Tabelle dargestellt, die die Fuzzy-Regeln zur Überlagerung der fuzzyfizierten Signale umfaßt, um die fuzzyfizierten Ergebnissignale zu erhalten. Zur Auswertung der in der Tabelle angegebenen Fuzzy-Regeln ist ferner eine UND-Verknüpfung erforderlich, die die Zugehörigkeitsgrade zum Auswerten der Fuzzy-Regeln (WENN-DANN) verknüpft. Im beschriebenen Ausführungsbeispiel ist die UND-Verknüpfung durch die Minimumsfunktion gegeben.

Die Inferenzeinheit 43 weist eine WENN-Seite 90 und eine DANN-Seite 91 auf. Auf der WENN-Seite 90 sind die fuzzyfizierten Signale, die als Eingangssignale in die Inferenzeinheit 43 eingehen, aufgeführt. In dem beschriebenen Ausführungsbeispiel sind dies das Signal, das die Anzahl der Einbrüche der Kathodenspannung (ARC) pro Zeiteinheit angibt, und das Signal, das die Differenz zwischen dem Sollwert der Kathodenspannung und dem Istwert der Kathodenspannung angibt. Allerdings sind auch weitere Signale denkbar, z.B. ein Signal, das sich aus dem Kathodenstrom der Kathode 9 ergibt und das bereits über die Leitung 29 an die Regelschaltung 20 übertragen wird, und ein Signal, das von der Regelschaltung 20 aufgrund des Alters bzw. der bisherigen Betriebsdauer des Sputtertargets 10 ermittelt wird. Auf der DANN-Seite 91 stehen die linguistischen Variablen für die fuzzyfizierten Ergebnissignale, wobei in dem beschriebenen Ausführungsbeispiel wahlweise die Ergebnisse der Spalte 92 oder der Spalte 93 zur Beeinflussung der Stellgröße, die den Gasfluß des Reaktivgases vorgibt, verwendet werden können. Durch die in der Spalte 92 aufgeführten linguistischen Variablen "wenig", "mittel" und "viel" wird eine absolute Regelung des Gasflusses des Reaktivgases erreicht, indem nach erfolgter Bearbeitung durch die Einheiten 44, 45 ein Absolutwert für den Gasfluß des Reaktivgases bereitgestellt wird. Durch die Wahl der Spalte 93 wird durch die Auswahl der linguistischen Variablen "weniger", "konstant" und "mehr" erreicht, daß nach erfolgter Bearbeitung durch die Einheiten 44, 45 eine relative Änderung des Gasflusses des Reaktivgases ausgehend von dem derzeitigen Wert des Gasflusses erzeugt wird. Die Auswahl, ob die Ergebnisse der Spalte 92 oder die Ergebnisse der Spalte 93 verwendet werden, kann von einem Operator, insbesondere einem Anlagenfahrer, der Kontrolleinheit 41 oder der Überwachungseinheit 45, z.B. in Abhängigkeit davon, ob der Gasfluß des Reaktivgases in der Nähe des Sollwertes liegt oder nicht, übernommen werden.

Beispielsweise ergibt sich daraus, daß die Anzahl der ARCs pro Zeiteinheit zu 70 % "wenig" ist und der Sollwert abzüglich des Istwerts der Kathodenspannung zu 60 % negativ ist, ein Zugehörigkeitsgrad von 60 % für "viel" bzw. von 60 % für "mehr" für den Gasfluß des Reaktivgases.

In Fig. 5 sind unter "WENN" die jeweiligen Zugehörigkeitsgrade zu den linguistischen Variablen, die aus den obigen anhand der Fig. 4A und 4B beschriebenen Beispielswerten erhalten werden, eingetragen, woraus sich unter Berücksichtigung der Fuzzy-Regeln unter Zuhilfenahme der Minimumsfunktion als UND-Verknüpfung die unter "DANN" angegebenen Zugehörigkeitsgrade zu den linguistischen Variablen der fuzzyfizierten Ergebnissignale ergeben. Die fuzzyfizierten Ergebnissignale betreffen im beschriebenen Ausführungsbeispiel dabei den Gasfluß des Reaktivgases, wobei die Wahl zwischen dem auf den linguistischen Variablen der Spalte 92 beruhenden Ergebnissignal und dem auf den linguistischen Variablen der Spalte 93 beruhenden Ergebnissignal besteht. Die ermittelten Zugehörigkeitsgrade zu den Fuzzy-Mengen bzw. linguistischen Variablen werden von der Inferenzeinheit 43 mittels der Signalleitung 50 an die Defuzzyfizierungseinheit 44 weitergeleitet. In dem betrachteten Beispiel ergibt sich für den Gasfluß des Reaktivgases der Zugehörigkeitsgrad für "viel" zu 60 %, der für "mittel" zu 60 % und der für "wenig" zu 0 %. Für die Alternative gemäß Spalte 93 ergibt sich für den Zugehörigkeitsgrad zu "mehr" 60 %, für den Zugehörigkeitsgrad zu "weniger" 0 % und für den Zugehörigkeitsgrad zu "konstant" 60 % + 30 % + 0 % = 90 %. Daß die Summe der Zugehörigkeitsgrade für die fuzzyfizierten Ergebnissignale jeweils mehr als 100 % ergibt, ist für die nachfolgende Auswertung unerheblich, da die Defuzzyfizierungseinheit 44 implizit eine Normierung vornimmt.

Alternativ kann bei der Ermittlung der unscharfen Ergebnissignale 92, 93 für den Gasfluß des Reaktivgases ein Gewichtungsfaktor berücksichtigt werden. Beispielsweise kann jeder Eintrag in der für das Ergebnissignal 92 bereitgestellten Spalte der WENN-DANN-Tabelle, die in der Fig. 5 dargestellt ist, ein Gewichtungsfaktor zugeordnet werden, der vorzugsweise zwischen 0 und 1 liegt. Wird beispielsweise dem Eintrag in der Spalte für den Gasfluß 92, in dem die linguistische Variable "viel" aufgeführt ist, ein Gewichtungsfaktor von 0,2 zugeordnet, dann ergibt sich für den Zugehörigkeitsgrad zu "viel" statt 60%: 60%·0,2 = 12%. Entsprechend kann jedem Eintrag in der Spalte, die dem Gasfluß 23 zugeordnet ist, ein Gewichtungsfaktor zugeordnet werden.

Die Defuzzyfizierungseinheit 44 setzt die unscharfen Ergebnissignale in konkrete Ergebnissignale um, um eine Stellgröße zu erhalten, die eine definierte Vorgabe für den Gasfluß des Reaktivgases darstellt.

Die Defuzzyfizierungseinheit 44 erhält folgende Eingangssignale:

| Gasfluß des Reaktivgases (absolut) | |
|---|---|
| "wenig" | 0 % |
| "mittel" | 60 % |
| "viel" | 60 % |

und/oder

| Gasfluß des Reaktivgases (relativ) | |
|---|---|
| "weniger" | 0 % |
| "konstant" | 90 % |
| "mehr" | 60 % |

Dabei bezieht sich die Variable "Gasfluß des Reaktivgases (relativ)" auf eine Änderung des Gasflusses.

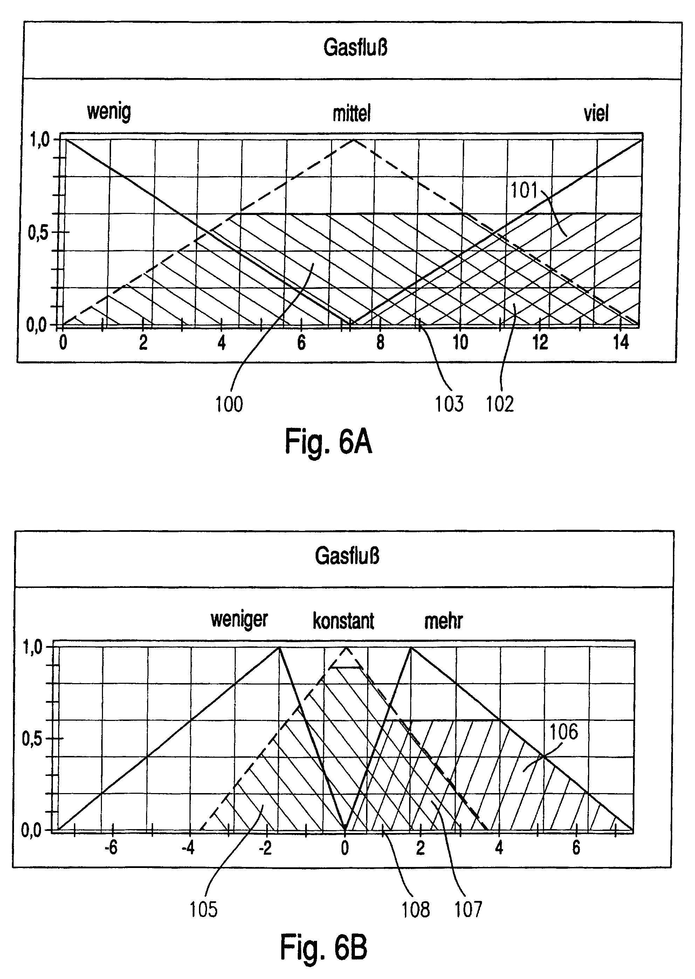

In Fig. 6A ist dargestellt, wie die Fuzzy-Mengen bezüglich der linguistischen Variablen "wenig", "mittel" und "viel" überlagert bzw. zur Inferenz gebracht werden, um das defuzzyfizierte Ergebnissignal für den Gasfluß des Reaktivgases zu erhalten. Die Fuzzy-Menge "mittel" wird bis zu einer Höhe, die 60 % entspricht, gefüllt, und die Fuzzy-Menge "viel" wird ebenfalls bis zu einer Höhe, die 60 % entspricht, gefüllt, während die Fuzzy-Menge für "wenig" nicht gefüllt wird, da der entsprechende Zugehörigkeitsgrad 0 % ist. Dadurch ergeben sich die Fläche 100, die der Fuzzy-Menge "mittel" zugeordnet ist, und die Fläche 101, die der Fuzzy-Menge "viel" zugeordnet ist, wobei sich die Flächen 100, 101 in einem Bereich 102 überlappen. Zur Defuzzyfizierung des fuzzyfizierten Ergebnissignals für den Gasfluß des Reaktivgases, d. h. der linguistischen Ausgangsvariablen für den Gasfluß des Reaktivgases, wird die x-Koordinate 103 des Schwerpunkts der beiden Flächen 100, 101 ermittelt, wobei der Überlagerungsbereich 102 nur einmal berücksichtigt wird. In dem beschriebenen Ausführungsbeispiel ergibt sich für die x-Koordinate 103 ein Wert von ungefähr +9,0, so daß der Gasfluß des Reaktivgases auf einen Wert einzustellen ist, der oberhalb des Schwerpunkts für "mittel" liegt. Da in dem beschriebenen Ausführungsbeispiel der Zugehörigkeitsgrad des ermittelten fuzzyfizierten Ergebnissignals für den Gasfluß des Reaktivgases bezüglich der linguistischen Variablen "wenig" 0 % ist, hat die in Fig. 6A dargestellte Fuzzy-Menge "wenig" in diesem Fall keinen Einfluß auf die Berechnung des Schwerpunkts.

Entsprechend wird auch das von der Inferenzeinheit 43 erzeugte bezüglich der linguistischen Variablen "weniger", "konstant" und "mehr" fuzzyfizierte Ergebnissignal für den Gasfluß des Reaktivgases in der Defuzzyfizierungseinheit 44 zur Überlagerung gebracht, um ein defuzzyfiziertes Ergebnissignal für den Gasfluß des Reaktivgases in Form eines diskreten Ergebniswertes zu erhalten. In dem beschriebenen Beispiel hat das fuzzyfizierte Ergebnissignal bezüglich der Fuzzy-Menge "weniger" einen Zugehörigkeitsgrad von 0 %, so daß in diesem Fall die Fuzzy-Menge "weniger" keinen Einfluß auf das Ergebnis hat. Die Fuzzy-Menge "konstant" wird bis auf eine Höhe, die 90 % entspricht, aufgefüllt, wodurch die Fläche 105 erhalten wird. Die Fuzzy-Menge "mehr" wird bis zu einer Höhe, die 60 % entspricht, aufgefüllt, wodurch die Fläche 106 erhalten wird. Die Flächen 105 und 106 überlagern sich in einem Überlagerungsbereich 107. Zur Defuzzyfizierung berechnet die Defuzzyfizierungseinheit 44 die x-Koordinate 108 des Schwerpunkts der Flächen 105, 106, wobei der Überlagerungsbereich 107 nur einmal herangezogen wird. In dem behandelten Beispiel ergibt sich für die x-Koordinate 108 des Schwerpunkts ungefähr ein Wert von 1,4, was bedeutet, daß der Gasfluß des Reaktivgases um 1,4 Einheiten zu erhöhen ist.

Die ermittelten Werte werden an die in Fig. 2 dargestellte Überwachungseinheit 45 von der Defuzzyfizierungseinheit 44 über die Signalleitung 51 übermittelt. Das Prozeßleitsystem 45 überwacht, ob das ausgewählte Ergebnissignal in dem vorgegebenen Bereich liegt. Falls das ausgewählte Ergebnissignal außerhalb des zugeordneten vorgegebenen Bereichs liegt, wird dieses auf einen vorgegebenen Maximal- bzw. Minimalwert begrenzt. Bei einer Bereichsüberschreitung erzeugt das Prozeßleitsystem 45 außerdem ein Fehlersignal, das diese an die Kontrolleinheit 41 weiterleitet. Durch das Fehlersignal wird einem Operator, insbesondere einer Bedienperson, angezeigt, daß eine Bereichsüberschreitung vorliegt bzw. erfolgt ist.

Im normalen Betrieb, d.h. wenn das Prozeßleitsystem 45 kein Fehlersignal ausgegeben hat, überprüft die Kontrolleinheit 41 die durch die Einheiten 42 bis 45 bestimmte Stellgröße für den Gasfluß des Reaktivgases und vergleicht diese mit den aus dem Prozeß 40 entnommenen Meßgrößen. Erst wenn die Meßgrößen in geeigneter Beziehung zu der ermittelten Stellgröße liegen, gibt die Kontrolleinheit 41 die Verarbeitung der Meßgrößen zur Ermittlung einer neuen Stellgröße für den Gasfluß des Reaktivgases durch die Einheiten 42 bis 45 frei. Dadurch wird gewährleistet, daß die Fuzzy-Regelung stets an den Prozeßparametern des Prozesses 40 orientiert ist und den Prozeßparametern nicht davon läuft.

Die Kontrolleinheit 41 kann außerdem so eingestellt sein, daß diese, falls das Prozeßleitsystem 45 ein Fehlersignal erzeugt bzw. erzeugt hat, solange die Freigabe zur Verarbeitung der Meßgrößen durch die Einheiten 42 bis 45 zur Erzeugung einer neuen Stellgröße für den Gasfluß des Reaktivgases unterdrückt, bis ein Operator, insbesondere eine Bedienperson, die Ausgabe wieder freigibt. Die Kontrolleinheit 41 kann bei der Freigabe durch den Operator so eingestellt werden, daß sie das Freigabesignal nachfolgend sogar dann ausgibt, wenn das Ergebnissignal für den Gasfluß des Reaktivgases, das von der Defuzzyfizierungseinheit 44 ermittelt wird, außerhalb des von dem Prozeßleitsystem 45 vorgegebenen Bereichs liegt.

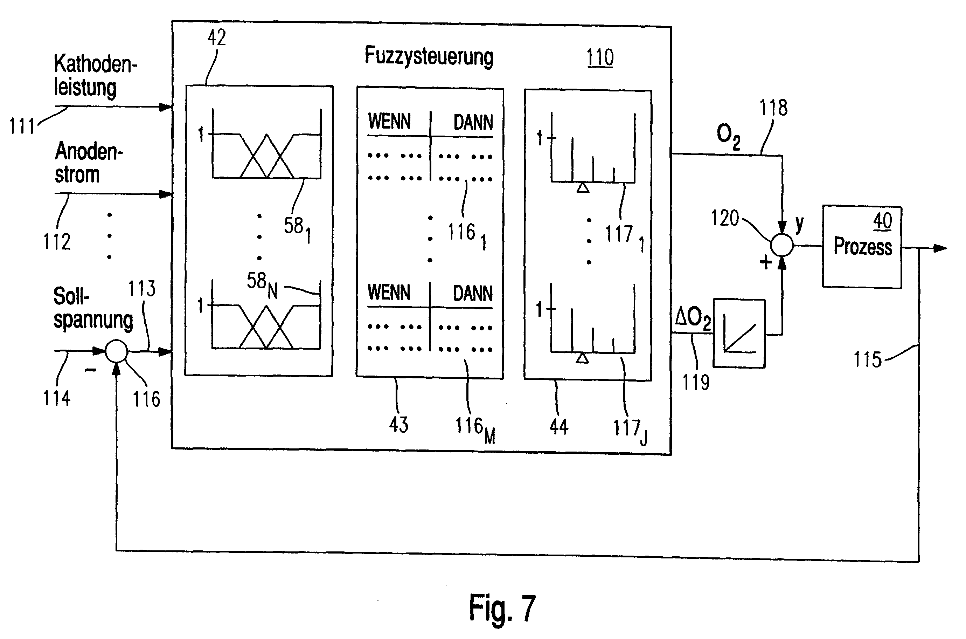

Fig. 7 zeigt einen Signalflußplan des Verfahrens zur Regelung einer Sputterbeschichtungsanlage gemäß einem weiteren Ausführungsbeispiel.

Die Fuzzysteuerung 110 umfaßt eine Fuzzyfizierungseinheit 42, eine Inferenzeinheit 43 und eine Defuzzyfizierungseinheit 44. Die Fuzzyfizierungseinheit 42 umfaßt mehrere Fuzzyfizierungsglieder 58₁ bis 58_{N}. Die Fuzzyfizierungsglieder 58₁ bis 58_{N} dienen zum fuzzyfizieren mehrerer Eingangssignale 111, 112 und 113. Dabei ist für jedes Eingangssignal 111 bis 113 ein Fuzzyfizierungsglied 58₁ bis 58_{N} vorgesehen. Beispielsweise wird die Sollspannung 114 mit einer gemessenen Spannung 115, die aus dem Prozeß 40 ermittelt wird, im Signalflußknoten 116 durch Subtraktion verrechnet und als Eingangssignal 113 von einem der Fuzzyfizierungsglieder 58₁ bis 58_{N} der Fuzzyfizierungseinheit 42 fuzzyfiziert. Weitere Eingangsgrößen können beispielsweise die Kathodenleistung 111 und der Anodenstrom 112 sein, die Verwendung dieser stellt allerdings eine vorteilhafte Weiterbildung der Erfindung dar, die nicht zwingend erforderlich ist.

Die Inferenzeinheit 43 umfaßt mehrere WENN-DANN-Blöcke 116₁ bis 116_{N}. Dadurch kann zwischen M Möglichkeiten ausgewählt werden, die N fuzzyfizierten Eingangssignale miteinander zur Inferenz zu bringen, um unscharfe Ausgangssignale zu erhalten, die an die Defuzzyfizierungseinheit 44 übergeben werden. Die Defuzzyfizierungseinheit 44 umfaßt die Defuzzyfizierungsglieder 117₁ bis 117_{J}. Wobei J so groß gewählt ist, daß unabhängig von der Wahl des WENN-DANN-Blocks 116₁ bis 116_{M} eine ausreichende Anzahl an Defuzzyfizierungsgliedern zur Verfügung steht, um die erhaltenen fuzzyfizierten Ausgangssignale in den Defuzzyfizierungsgliedern 117₁ bis 117_{J} zu defuzzyfizieren.

In dem in der Fig. 7 dargestellten Ausführungsbeispiel des Singalflußplans werden beispielsweise zwei der J Defuzzyfizierungsglieder 117₁ bis 117_{J} benötigt, um die defuzzyfizierten Ausgangssignale 118 und 119 zu erhalten. Dabei beschreibt das Signal 118 die Absolutmenge Sauerstoff O₂ und das Signal 119 beschreibt die Sauerstoffänderung ΔO₂. Im Signalflußknoten 120 werden die beiden Signale 118, 119 durch regelungstechnische Addition miteinander verknüpft, wodurch das Ausgangssignal Y erhalten wird, das den Prozeß 40 beeinflußt. Das aus dem Prozeß 40 erhaltene Signal 115 für die Meßspannung wird anschließend mit dem Eingangssignal 114, das die Sollspannung beschreibt, überlagert, um den Regelungskreis zu schließen.

In diesem Ausführungsbeispiel der Erfindung errechnen die Defuzzyfizierungsglieder 117₁ bis 117_{J} der Defuzzyfizierungseinheit 44 die defuzzyfizierten Ausgangssignale über die Singleton-Methode. Bei der Singleton-Methode wird jeder unscharfe Begriff als Peak der Höhe 1 beschrieben, der mit dem entsprechenden Zugehörigkeitsgrad multipliziert wird. Das Ergebnis der Defuzzyfizierung ergibt sich dann als Mittelwert der gewichteten Summe über die Abszissenwerte der jeweils als Peak dargestellten linguistischen Variablen.

Die Erfindung ist nicht auf das beschriebene Ausführungsbeispiel beschränkt. Insbesondere können in der Inferenzeinheit 43 andere Fuzzy-Regeln verwendet werden. Außerdem kann auch eine andere Anzahl an linguistischen Variablen für jedes der zu fuzzyfizierenden Signale vorgesehen werden. Ferner können die Fuzzy-Mengen eine von den dargestellten Mengen abweichende Gestalt aufweisen. Außerdem können auch weitere Prozeßparameter gemessen und von der Regelschaltung mittels der Fuzzy-Logik verarbeitet werden.

## Patentansprüche

1. Sputterbeschichtungsanlage (1) zur Beschichtung von zumindest einem Substrat (2, 3), insbesondere einer Glasscheibe, mit
zumindest einer Kathode (9), die mit einem Sputtertarget (10) verbunden ist,
zumindest einer Anode (7) und
zumindest einem Gaseinlaß (15, 16), durch den ein Reaktivgas in den Raum (17) zwischen der Anode (7) und dem Substrat (2, 3) beziehungsweise dessen Transporteinrichtung (4) geleitet wird,
wobei die Kathode (9) gegenüber der Anode (7) mit einer Kathodenspannung beaufschlagt ist, um zwischen der Kathode (9) und der Anode (7) ein Plasma auszubilden,
**gekennzeichnet durch**
eine Regelschaltung (20), die die Meßgröße, die die Kathodenspannung angibt, und die Meßgröße, die die Einbrüche der Kathodenspannung angibt, die infolge Entladung der Kathode (9) über das Plasma auftreten, erfaßt und in Abhängigkeit von diesen Meßgrößen den Gasfluß des Reaktivgases basierend auf einer Fuzzylogik steuert.

2. Sputterbeschichtungsanlage nach Anspruch 1,
**dadurch gekennzeichnet,**
**daß** die Regelschaltung (20) eine Fuzzyfizierungseinheit (42) umfaßt, die die Meßgrößen in fuzzyfizierte Signale umsetzt.

3. Sputterbeschichtungsanlage nach Anspruch 2,
**dadurch gekennzeichnet,**
**daß** ein Zeitgeber (54) vorgesehen ist, der ein Taktsignal erzeugt,
**daß** die Meßgröße, die die Einbrüche der Kathodenspannung angibt, mit dem Taktsignal zu einem Signal umsetzt wird, das die Anzahl der Einbrüche der Kathodenspannung pro Zeiteinheit angibt, und
**daß** die Fuzzyfizierungseinheit (42) das durch die Umsetzung erhaltene Signal fuzzyfiziert.

4. Sputterbeschichtungsanlage nach Anspruch 3,
**dadurch gekennzeichnet,**
**daß** ein Kathodenspannung-Sollwertspeicher (59) vorgesehen ist, der einen Sollwert für die Kathodenspannung bereitstellt,
**daß** der Istwert der Kathodenspannung mit dem Sollwert der Kathodenspannung zu einem Signal verrechnet wird, und
**daß** die Fuzzyfizierungseinheit (42) das durch die Verrechnung erhaltene Signal fuzzyfiziert.

5. Sputterbeschichtungsanlage nach Anspruch 4,
**dadurch gekennzeichnet,**
**daß** in dem Kathodenspannung-Sollwertspeicher (59) mehrere Sollwerte für die Kathodenspannung der Kathode (9) hinterlegt sind, die verschiedenen Sputtertargets (10) zugeordnet sind.

6. Sputterbeschichtungsanlage nach einem der Ansprüche 2 bis 5,
**dadurch gekennzeichnet,**
**daß** die Regelschaltung (20) eine Kontrolleinheit (41) aufweist,
**daß** die Regelschaltung (20) nur dann einen neuen Wert für der Gasfluß des Reaktivgases ausgibt, wenn die Kontrolleinheit (41) ein Freigabesignal ausgibt, und
**daß** die Kontrolleinheit (41) das Freigabesignal ausgibt, wenn der gemessene Istwert des Gasflusses des Reaktivgases innerhalb eines vorgegebenen Bereichs um dem Sollwert des Gasflusses des Reaktivgases liegt.

7. Sputterbeschichtungsanlage nach einem der Ansprüche 2 bis 6,
**dadurch gekennzeichnet,**
**daß** die Regelschaltung (20) eine Inferenzeinheit (43) umfaßt, die die von der Fuzzyfizierungseinheit (42) ausgegebenen fuzzyfizierten Signale aufgrund von Fuzzyregeln miteinander verknüpft, um zumindest ein fuzzyfiziertes Ergebnissignal für den Gasfluß des Reaktivgases zu erhalten.

8. Sputterbeschichtungsanlage nach Anspruch 7,
**dadurch gekennzeichnet,**
**daß** die Regelschaltung (20) eine Defuzzifizierungseinheit (44), die das fuzzyfizierte Ergebnissignal für den Gasfluß des Reaktivgases in ein diskretes Ergebnissignal für den Gasfluß des Reaktivgases defuzzyfiziert, und ein Prozeßleitsystem (45) umfaßt, das überwacht, ob das Ergebnissignal in einem vorgegebenen Bereich liegt und, falls das Ergebnissignal außerhalb des zugeordneten vorgegebenen Bereichs liegt, dieses auf einen vorgegebenen Maximal- beziehungsweise Minimalwert begrenzt,
wobei der Gasfluß des Reaktivgases aufgrund des Ergebnissignals neu eingestellt wird.

9. Sputterbeschichtungsanlage nach Anspruch 8,
**dadurch gekennzeichnet,**
**daß** das Prozeßleitsystem (45), falls das Ergebnissignal für den Gasfluß des Reaktivgases den vorgegebenen Bereich überschritten hat, ein Fehlersignal erzeugt, das eine Bereichsüberschreitung des Ergebnissignals anzeigt.

10. Sputterbeschichtungsanlage nach Anspruch 9,
**dadurch gekennzeichnet,**
**daß** die Kontrolleinheit(41), falls das Prozeßleitsystem (45) ein Fehlersignal erzeugt, solange kein Freigabesignal, das die Ausgabe eines neuen Wertes für den Gasfluß des Reaktivgases freigibt, ausgibt, bis durch einen Operator, insbesondere eine Bedienperson, die Ausgabe wieder freigegeben ist.

11. Sputterbeschichtungsanlage nach Anspruch 10,
**dadurch gekennzeichnet,**
**daß**, falls das Prozeßleitsystem (45) ein Fehlersignal erzeugt und durch den Operator die Ausgabe des Freigabesignals der Kontrolleinheit (41) freigegeben ist, die Kontrolleinheit (41) das Freigabesignal sogar dann ausgibt, wenn das Ergebnissignal für den Gasfluß des Reaktivgases weiterhin außerhalb des vorgegebenen Bereichs liegt.

12. Sputterbeschichtungsanlage nach einem der Ansprüche 1 bis 11,
**dadurch gekennzeichnet,**
**daß** zwischen der Kathode (9) und der Anode (7) zumindest zum Teil ein Inertgas vorgesehen ist.

13. Verfahren zur Regelung einer Sputterbeschichtungsanlage (1), die zur Beschichtung von zumindest einem Substrat (2, 3), insbesondere einer Glasscheibe, dient und zumindest eine Kathode (9), die mit einem Sputtertarget (10) verbunden ist, zumindest eine Anode (7) und zumindest einen Gaseinlaß (15, 16) aufweist, durch den ein Reaktivgas in den Raum (17) zwischen der Anode (7) und dem Substrat (2, 3) geleitet wird, wobei die Kathode (9) gegenüber der Anode (7) mit einer Kathodenspannung beaufschlagt wird, um zwischen der Kathode (9) und der Anode (7) ein Plasma auszubilden,
**gekennzeichnet durch** folgende Verfahrensschritte:
a) Messen der Kathodenspannung der Kathode (9);
b) Messen der Anzahl der Einbrüche der Kathodenspannung, die infolge Entladung der Kathode (9) über das Plasma auftreten; und
c) Verarbeiten der Meßgrößen Kathodenspannung und Anzahl der Einbrüche der Kathodenspannung unter Anwendung von vorbestimmten Fuzzyregeln zur Regelung des Gasflusses des Reaktivgases.

14. Verfahren nach Anspruch 13,
**dadurch gekennzeichnet,**
**daß** im Verfahrensschritt (c) die Anzahl der Einbrüche der Kathodenspannung unter Verwendung eines Taktsignals in ein Signal umgesetzt wird, das die Anzahl der Einbrüche der Kathodenspannung pro Zeiteinheit angibt, und
**daß** dieses Signal bezüglich der linguistischen Variablen "wenig", "mittel" und "viel" zu einem fuzzyfizierten Signal fuzzyfiziert wird; und
**daß** der Istwert der Kathodenspannung von einem Sollwert der Kathodenspannung abgezogen wird und das Ergebnis bezüglich der linguistischen Variablen "negativ", "Null" und "positiv" zu einem fuzzyfizierten Signal fuzzifiziert wird.

15. Verfahren nach Anspruch 14,
**dadurch gekennzeichnet,**
**daß** die fuzzyfizierten Signale gemäß vorgegebenen Fuzzyregeln miteinander überlagert werden, wodurch ein bezüglich der linguistischen Variablen "wenig", "mittel" und "viel" fuzzyfiziertes Ergebnissignal für den Gasfluß erhalten wird; und
**daß** das fuzzyfizierte Ergebnissignal auf ein diskrete Ergebnissignal defuzzyfiziert wird.

16. Verfahren nach Anspruch 15,
**dadurch gekennzeichnet,**
**daß** die Fuzzyregeln folgende Regeln umfassen:
"wenig" UND "negativ" ist gleich "viel";
"wenig" UND "Null" ist gleich "mittel";
"wenig" UND "positiv" ist gleich "wenig";

17. Verfahren nach Anspruch 14,
**dadurch gekennzeichnet,**
**daß** die fuzzyfizierten Signale gemäß vorgegebenen Fuzzyregeln miteinander verknüpft werden, wodurch ein bezüglich der linguistischen Variablen "weniger", "konstant" und "mehr" fuzzyfiziertes Ergebnissignal für den Gasfluß des Reaktivgases erhalten wird; und
**daß** das fuzzyfizierte Ergebnissignal auf ein diskretes Ergebnissignal defuzzyfiziert wird.

18. Verfahren nach Anspruch 17,
**dadurch gekennzeichnet,**
**daß** die Fuzzyregeln folgende Regeln umfassen:
"wenig" UND "negativ" ist gleich "mehr";
"wenig" UND "Null" ist gleich "konstant";
"wenig" UND "positiv" ist gleich "weniger";
"mittel" ist gleich "konstant"; und
"viel" ist gleich "konstant".

19. Verfahren nach Anspruch 16 oder 18,
**dadurch gekennzeichnet,**
**daß** die in den Fuzzyregeln angegebene UND-Verknüpfung die Zugehörigkeitsgrade zu den linguistischen Variablen "wenig", "negativ", "Null" und "positiv" mittels der Minimumsfunktion verknüpft.

20. Verfahren nach einem der Ansprüche 13 bis 19,
**dadurch gekennzeichnet,**
**daß** zwischen der Kathode (9) und der Anode (7) zumindest zum Teil ein Inertgas vorgesehen ist.

## Claims

1. Sputter coating plant (1) for coating at least one substrate (2, 3), in particular a glass pane, with
at least one cathode (9), connected to a sputter target (10), at least one anode (7) and
at least one gas inlet (15, 16) through which a reactive gas is conducted into the space (17) between the anode (7) and the substrate (2, 3) or its conveyor device (4),
wherein the cathode (9) is charged with a cathode voltage in respect of the anode (7), in order to form a plasma between the cathode (9) and the anode (7),
**characterised by**
a control circuit (20) which records the measurement variable indicating the cathode voltage and the measurement variable indicating the dips in the cathode voltage occurring as a result of discharging of the cathode (9) via the plasma and as a function of these measurement variables controls the gas flow of the reactive gas based on a fuzzy logic.

2. Sputter coating plant according to claim 1,
**characterised in that** the control circuit (20) comprises a fuzzifying unit (42) which converts the measurement variables into fuzzified signals.

3. Sputter coating plant according to claim 2,
**characterised in that**
a timer (54) is provided which generates a clock signal,
the measurement variable indicating the dips in the cathode voltage is converted by the clock signal into a signal indicating the number of dips in the cathode voltage per time unit and
the fuzzifying unit (42) fuzzifies the signal obtained by the conversion.

4. Sputter coating plant according to claim 3,
**characterised in that**
a cathode voltage desired value memory (59) is provided, which produces a desired value for the cathode voltage,
the actual value of the cathode voltage is set against the desired value of the cathode voltage to form a signal and
the fuzzifying unit (42) fuzzifies the signal obtained by the offsetting.

5. Sputter coating plant according to claim 4,
**characterised in that**
filed in the cathode voltage desired value memory (59) are several desired values for the cathode voltage of the cathode (9) allocated to various sputter targets (10).

6. Sputter coating plant according to one of claims 2 to 5,
**characterised in that**
the control circuit (20) has a checking unit (41),
the control circuit (20) outputs a new value for the gas flow of the reactive gas only if the checking unit (41) outputs a release signal and
the checking unit (41) outputs the release signal if the measured actual value of the gas flow of the reactive gas is within a preset range around the desired value of the gas flow of the reactive gas.

7. Sputter coating plant according to one of claims 2 to 5,
**characterised in that**
the control circuit (20) comprises an inference unit (43) which links the fuzzified signals output by the fuzzifying unit (42) to one another on the basis of fuzzy rules, in order to obtain at least one fuzzified result signal for the gas flow of the reactive gas.

8. Sputter coating plant according to claim 7,
**characterised in that**
the control circuit (20) comprises a defuzzifying unit (44) which defuzzifies the fuzzified result signal for the gas flow of the reactive gas into a discrete result signal for the gas flow of the reactive gas and a process control system (45) which monitors whether the result signal is in a preset range and, if the result signal is outside the allocated preset range, limits it to a preset maximum or minimum value,
wherein the gas flow of the reactive gas is reset on the basis of the result signal.

9. Sputter coating plant according to claim 8,
**characterised in that**
if the result signal for the gas flow of the reactive gas has exceeded the preset range, the process control system (45) generates an error signal which indicates that the result signal has exceeded the range.

10. Sputter coating plant according to claim 9,
**characterised in that**
if the process control system (45) generates an error signal, the checking unit (41) does not output a release signal releasing the output of a new value for the gas flow of the reactive gas until output has been re-released by an operator, in particular a human operator.

11. Sputter coating plant according to claim 10,
**characterised in that**
if the process control system (45) generates an error signal and output of the release signal has been released to the checking unit (41) by the operator, the checking unit (41) outputs the release signal even if the result signal for the gas flow of the reactive gas is still outside the preset range.

12. Sputter coating plant according to one of claims 1 to 11,
**characterised in that**
an inert gas is provided, at least partially, between the cathode (9) and the anode (7).

13. Method for controlling a sputter coating plant (1) serving to coat at least one substrate (2, 3), in particular a glass pane, and having at least one cathode (9) connected to a sputter target (10), at least one anode (7) and at least one gas inlet (15, 16) through which a reactive gas is conducted into the space (17) between the anode (7) and the substrate (2, 3), the cathode (9) being charged in respect of the anode (7) with a cathode voltage, in order to form a plasma between the cathode (9) and the anode (7),
**characterised by** the following method steps:
a) measuring the cathode voltage of the cathode (9);
b) measuring the number of dips in the cathode voltage occurring as a result of discharging of the cathode (9) via the plasma and
c) processing the measurement variables of cathode voltage and number of dips in the cathode voltage, using predetermined fuzzy rules for controlling the gas flow of the reactive gas.

14. Method according to claim 13,
**characterised in that**
in method step c) the number of dips in the cathode voltage is converted using a clock signal into a signal indicating the number of dips in the cathode voltage per time unit and
this signal is fuzzified into a fuzzified signal referring to the linguistic variables "little", "average" and "a great deal" and
the actual value of the cathode voltage is derived from a desired value of the cathode voltage and the result is fuzzified into a fuzzified signal referring to the linguistic variables "negative", "zero" and "positive".

15. Method according to claim 14,
**characterised in that**
the fuzzified signals are overlaid by one another according to preset fuzzy rules, whereby a result signal for the gas flow fuzzified referring to the linguistic variables "little", "average" and "a great deal" is obtained and
the fuzzified result signal is defuzzified to a discrete result signal.

16. Method according to claim 15,
**characterised in that**
the fuzzy rules comprise the following rules:
"little" AND "negative" equals "a great deal";
"little" AND "zero" equals "average";
"little" AND "positive" equals "little".

17. Method according to claim 14,
**characterised in that**
the fuzzified signals are linked to one another according to preset fuzzy rules, whereby a result signal for the gas flow of the reactive gas fuzzified referring to the linguistic variables "less", "constant" and "more" is obtained and
the fuzzified result signal is defuzzified to a discrete result signal.

18. Method according to claim 17,
**characterised in that**
the fuzzy rules comprise the following rules:
"little" AND "negative" equals "more";
"little" AND "zero" equals "constant";
"little" AND "positive" equals "less"
"average" equals "constant" and
"a great deal" equals "constant".

19. Method according to claim 16 or 18,
**characterised in that**
the AND operation cited in the fuzzy rules links the associated grades to the linguistic variables "little", "negative", "zero" and "positive" by means of the minimum function.

20. Method according to one of claims 13 to 19,
**characterised in that**
an inert gas is provided at least partially between the cathode (9) and the anode (7).

## Revendications

1. Dispositif de pulvérisation (1) pour le revêtement d'au moins un substrat (2, 3), en particulier d'une vitre, avec
au moins une cathode (9) qui est reliée à une cible de pulvérisation (10),
au moins une anode (7) et
au moins une entrée de gaz (15, 16) par laquelle un gaz réactif est acheminé dans l'espace (17) entre l'anode (7) et le substrat (2, 3) de préférence son dispositif de transport (4),
la cathode (9) étant alimentée par rapport à l'anode (7) avec une tension cathodique pour former un plasma entre la cathode (9) et l'anode (7), **caractérisé en ce que**
un circuit de réglage (20) qui saisit la grandeur de mesure indiquant la tension cathodique et la grandeur de mesure qui indique les chutes de tension cathodique survenant en conséquence de la décharge de la cathode (9) sur le plasma, commande en fonction de ces grandeurs de mesure le débit gazeux du gaz réactif sur la base d'une logique floue.

2. Dispositif de pulvérisation selon la revendication 1, **caractérisé en ce que** le circuit de réglage (20) comprend une unité de logique floue (42) qui transforme les grandeurs de mesure en signaux en logique floue.

3. Dispositif de pulvérisation selon la revendication 2, **caractérisé en ce que** une horloge (54) est prévue, qui produit un signal d'horloge,
**en ce que** la grandeur de mesure qui indique les chutes de tension cathodique est transformée avec le signal d'horloge, en un signal qui indique le nombre de chutes de tension cathodique par unité de temps, et
**en ce que** l'unité de logique floue (42) transforme le signal obtenu par la transformation de logique floue.

4. Dispositif de pulvérisation selon la revendication 3, **caractérisé en ce qu'**une mémoire de la valeur de consigne de la tension cathodique (59) est prévue, qui met à disposition une valeur de consigne pour la tension cathodique,
**en ce que** la valeur réelle de la tension cathodique est transformée avec la valeur de consigne de la tension cathodique en un signal et
**en ce que** l'unité de logique floue (42) transforme le signal obtenu en signal de logique floue.

5. Dispositif de pulvérisation selon la revendication 4, **caractérisé en ce que** dans la mémoire de la valeur de consigne de la tension cathodique (59), plusieurs valeurs de consigne pour la tension cathodique de la cathode (9) sont enregistrées, lesquelles sont affectées à différentes cibles de pulvérisation (10).

6. Dispositif de pulvérisation selon l'une quelconque des revendications 2 à 5, **caractérisé en ce que** le circuit de réglage (20) présente une unité de contrôle (41),
**en ce que** le circuit de réglage (20) n'indique une nouvelle valeur pour le débit gazeux du gaz réactif que lorsque l'unité de contrôle (41) émet un signal de déclenchement et que l'unité de contrôle (41) émet le signal de déclenchement lorsque la valeur réelle du débit gazeux du gaz réactif se situe dans une plage prédéterminée autour de la valeur de consigne du débit gazeux du gaz réactif.

7. Dispositif de pulvérisation selon l'une quelconque des revendications 2 à 6, **caractérisé en ce que** le circuit de réglage (20) comprend une unité d'inférence (43) qui relie conjointement les signaux en logique floue émis à partir de l'unité de logique floue (42) sur la base de règles de logique floue, pour obtenir au moins un signal de résultat en logique floue pour le débit gazeux du gaz réactif.

8. Dispositif de pulvérisation selon la revendication 7, **caractérisé en ce que** le circuit de réglage (20) comprend une unité de logique floue inverse (44) qui transforme le signal de résultat en logique floue pour le débit gazeux du gaz réactif en un signal de résultat discret pour le débit gazeux du gaz réactif, et un système de conduit de processus (45) qui surveille si le signal de résultat se situe dans une plage prédéterminée, et, si le signal de résultat se situe en dehors de la plage préalablement affectée, limite celui-ci à une valeur maximale ou minimale prédéterminée,
le débit gazeux du gaz réactif étant réglé à nouveau sur la base du signal de résultat.

9. Dispositif de pulvérisation selon la revendication 8, **caractérisé en ce que** le système de conduite du processus (45) produit, si le signal de résultat pour le débit gazeux du gaz réactif a dépassé la plage prédéterminée, un signal d'erreur qui indique un dépassement de plage du signal de résultat.

10. Dispositif de pulvérisation selon la revendication 9, **caractérisé en ce que**, si le système de conduite du processus (45) produit un signal d'erreur, l'unité de contrôle (41) émet, tant qu'aucun signal de déclenchement n'est donné, l'édition d'une nouvelle valeur pour le débit de gaz du gaz réactif, jusqu'à ce qu'un opérateur, en particulier un manipulateur déclenche à nouveau l'émission.

11. Dispositif de pulvérisation selon la revendication 10, **caractérisé en ce que**, si le système de conduite du processus (45) produit un signal d'erreur et que l'opérateur débloque l'émission du signal de déclenchement de l'unité de contrôle (41), l'unité de contrôle (41) n'émet le signal de déclenchement que lorsque le signal de résultat pour le débit gazeux du gaz réactif continue à se situer en dehors de la plage prédéterminée.

12. Dispositif de pulvérisation selon l'une quelconque des revendications 1 à 11, **caractérisé en ce que**, entre la cathode (9) et l'anode (7), un gaz inerte est prévu au moins pour partie.

13. Procédé de réglage d'un dispositif de pulvérisation (1) qui sert à revêtir au moins un substrat (2, 3), en particulier une vitre, et qui présente au moins une cathode (9) reliée à une cible de pulvérisation (10), au moins une anode (7) et au moins une entrée de gaz (15, 16) au travers de laquelle un gaz réactif est introduit dans l'espace (17) entre l'anode (7) et le substrat (2, 3), la cathode (9) étant alimentée par rapport à l'anode (7) avec une tension cathodique pour constituer un plasma entre la cathode (9) et l'anode (7), **caractérisé par** les étapes de procédé suivantes :
a) mesure de la tension cathodique de la cathode (9) ;
b) mesure du nombre de chutes de tension cathodique qui surviennent en conséquence d'une décharge de la cathode (9) sur le plasma ; et
c) transformation des grandeurs de mesure de la tension cathodique et du nombre de chutes de tension cathodique en utilisant les règles de logique floue prédéterminées pour régler le débit gazeux du gaz réactif.

14. Procédé selon la revendication 13, **caractérisé en ce que**
à l'étape (c) du procédé, le nombre des chutes de tension cathodique est transformé en utilisant un signal d'horloge, en un signal qui indique le nombre de chutes de tension cathodique par unité de temps, et
**en ce que** ce signal est transformé en un signal en logique floue par rapport aux variables sémantiques "peu", "moyen" et "beaucoup" ; et
**en ce que** la valeur réelle de la tension cathodique est soustraite d'une valeur de consigne de la tension cathodique et le résultat relatif aux variables sémantiques "négatif", "nul" et "positif" est transformé en un signal en logique floue.

15. Procédé selon la revendication 14, **caractérisé en ce que** les signaux en logique floue selon les règles de logique floue prédéterminées sont superposés, un signal de résultat en logique floue relatif aux variables sémantiques "peu", "moyen" et "beaucoup" étant obtenu pour le débit gazeux ; et
**en ce que** le signal de résultat en logique floue est transformé en inverse en un signal de résultat discret.

16. Procédé selon la revendication 15, **caractérisé en ce que**
les règles de logique floue comprennent les règles suivantes :
"peu" ET "négatif" égale "beaucoup" ;
"peu" ET "nul" égale "moyen" ;
"peu" ET "positif" égale "peu".

17. Procédé selon la revendication 14, **caractérisé en ce que** les signaux en logique floue selon les règles de logique floue prédéterminées sont reliés les uns aux autres, un signal de résultat en logique floue relatif aux variables sémantiques "moins", "constant" et "plus" étant obtenu pour le débit gazeux du gaz réactif ; et
**en ce que** le signal de résultat en logique floue est transformé en inverse en un signal de résultat discret.

18. Procédé selon la revendication 17, **caractérisé en ce que**
les règles de logique floue comprennent les règles suivantes :
"peu" ET "négatif" égale "plus" ;
"peu" ET "nul" égale "constant" ;
"peu" ET "positif" égale "moins" ;
"moyen" est égal à "constant" ; et
"beaucoup" est égal à "constant".

19. Procédé selon la revendication 16 ou 18, **caractérisé en ce que** la relation ET indiquée dans les règles de logique floue relie le degré d'appartenance aux variables sémantiques "peu", "négatif", "nul" et "positif" au moyen de la fonction minimale.

20. Procédé selon l'une quelconque des revendications 13 à 19, **caractérisé en ce que**, entre la cathode (9) et l'anode (7) est prévu au moins pour partie un gaz inerte.
